# EUROPEAN PATENT APPLICATION

(11) **EP 4 580 334 A1**
(43) Date of publication of application: **02.07.2025**
(21) Application number: 24215516.6
(22) Date of filing: 26.11.2024
(51) Int. Cl.: H10D 30/01, H10D 84/01, H10D 30/43, H10D 88/00, H10D 84/85

(54) **AIR-GAPPED ISOLATION WALLS**

(30) Priority: 26.12.2023 US 202318396209
(71) Applicant: INTEL Corporation, Santa Clara, CA 95054 (US)
(72) Inventor: MANNEBACH, Ehren, Beaverton, 97007 (US); PHAN, Anh, Beaverton, 97007 (US); LILAK, Aaron D., Beaverton, 97007 (US); DESAI, Umang, Portland, 97225 (US); CEKLI, Seda, Portland, 97223 (US); WADEKAR, Shardul, Hillsboro, 97123 (US); STOLT, Madeleine, Beaverton, 97006 (US)
(74) Representative: 2SPL Patentanwälte PartG mbB

(57) **Abstract**

Air gaps are incorporated into a transistor layer to reduce capacitance between conductive components. In some embodiments, along a gate cut region extending across the gates of multiple transistors, a gate cut dielectric may be partially or fully replaced by an air gap. The air gap may extend between two adjacent gates of two adjacent transistors, or between a gate and a via, where the via extends through the gate line and between two gates. As another example, air gaps may extend between adjacent source or drain regions between pairs of adjacent transistors, e.g., in a device that includes back side source or drain contacts. The air gap may be formed on the back side of the device. The air gaps are capped by a dielectric material, so that additional layers (e.g., back side interconnect layers) may be formed over the air gap.

## Description

### Background

Conventional transistors have a channel extending between a source region and a drain region, and a gate over the channel to turn the transistor on or off. The source region and drain region are each coupled to a respective contact that applies a current to the region. Similarly, the gate is connected to a contact to apply a current to the gate. Interconnect layers over a layer of transistors provide electrical connections to the transistors and to external devices and/or power supplies. In some IC designs, interconnect layers may be formed on both sides of the transistors, e.g., on a front side and a back side. For example, in some devices, gate, source, and/or drain contacts may be moved to the back side of the device. In some devices, power and/or signal connections may be formed on a back side of the device and extend through the transistor layer to the front side.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a cross-section across a nanoribbon-based transistor showing the source, gate, and drain, according to some embodiments of the present disclosure.
FIG. 1B is a cross-section of the nanoribbon-based transistor through the plane AA' in FIG. 1A, according to some embodiments of the present disclosure.
FIG. 2 is a flow diagram of a process for fabricating a device with air gaps in the transistor layer, according to some embodiments of the present disclosure.
FIG. 3A is a cross-section of a portion of a transistor layer over a front side metal layer, according to some embodiments of the present disclosure.
FIG. 3B is a cross-section through the plane CC' in FIG. 3A, according to some embodiments of the present disclosure.
FIG. 4 is a cross-section illustrating etching of portions of the gate cut dielectric, according to some embodiments of the present disclosure.
FIG. 5 is a cross-section illustrating deposition of a dielectric cap over the air gaps, according to some embodiments of the present disclosure.
FIG. 6 is a cross-section illustrating exposure of the vias through the transistor layer, according to some embodiments of the present disclosure.
FIG. 7A is a cross-section illustrating back side metal layers over the air gaps, according to some embodiments of the present disclosure.
FIG. 7B is an enlarged view of a portion of FIG. 7A, according to some embodiments of the present disclosure.
FIG. 8 is an enlarged view of air gaps surrounded by remaining gate cut dielectric, according to some embodiments of the present disclosure.
FIG. 9 is a cross-section illustrating air gaps within a transistor layer with back side interconnects, according to some embodiments of the present disclosure.
FIG. 10 is a cross-section illustrating air gaps within the transistor layers of a CFET device, according to some embodiments of the present disclosure.
FIGS. 11A and 11B are top views of a wafer and dies that include one or more transistor layers with air gapped isolation walls accordance with any of the embodiments disclosed herein.
FIG. 12 is a cross-sectional side view of an IC device that may include one or more transistor layers with air gapped isolation walls in accordance with any of the embodiments disclosed herein.
FIG. 13 is a cross-sectional side view of an IC device assembly that may include one or more transistor layers with air gapped isolation walls in accordance with any of the embodiments disclosed herein.
FIG. 14 is a block diagram of an example computing device that may include one or more transistor layers with air gapped isolation walls in accordance with any of the embodiments disclosed herein.

### Detailed Description

### Overview

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Transistor-based IC devices have isolation materials between different conductive components. The isolation materials provide electrical isolation between different components of transistors, e.g., between a gate and a source region. The isolation materials also provide electrical isolation between different transistors, e.g., between the gates of adjacent transistors.

In certain device architectures, parasitic capacitance between conductive components can degrade device performance. For example, there is a drive to reduce the feature size and increase density on IC chips. As transistor sizes decrease and transistor density increases, tightly-spaced conductive features (e.g., closely-packed gate lines) are subject to parasitic capacitance between adjacent features. As another example, in some designs, power may be delivered through the back side of an IC device, and the power can be routed to the front side of the IC device through the transistor layer. Power delivery vias extending through the transistor layer between adjacent gates can create unwanted capacitance with conductive gates, for example. As another example, back side contacts (e.g., back side source or drain contacts) can create parasitic capacitance with gate lines or other components.

Typically, a dielectric material is used as an isolation material between different conductive components in an IC device. Capacitance is proportional to the dielectric constant or relative permittivity of the material between two conductors, e.g., two adjacent gates, or a gate and a via next to the gate. Materials having a higher dielectric constant resulting in greater capacitance. Reducing the dielectric constant reduces the capacitance between conductors. Silicon dioxide is a common dielectric material that has a dielectric constant of 3.9. Dielectric materials with higher dielectric constants, such as silicon nitride, are often used between gates, as higher-k materials are often more robust than lower-k materials. Air gaps, with a dielectric constant of around 1, dramatically reduce capacitance relative to common dielectric materials.

As described herein, air gaps are incorporated into the device layer to reduce capacitance between conductive components of the IC device. For example, along a gate cut region extending across the gates of multiple transistors, a gate cut dielectric (e.g., silicon nitride) may be partially or fully replaced by an air gap. The air gap may extend between two adjacent gates (of two adjacent transistors), or between a gate and a via that extends through the gate line, between two gates. As another example, air gaps may extend between adjacent source or drain regions of pairs of adjacent transistors, e.g., in a device that includes back side source or drain contacts.

The air gap may be formed from the back side of the transistor layer. For example, a transistor layer may be formed over a support structure, followed by several layers of front side interconnect. The device may then be flipped and the support structure removed to expose the back side of the transistor layer. Material in the transistor layer is etched from the back side to create the air gaps. The air gaps are then capped by a dielectric material, so that additional layers (e.g., back side interconnect layers) may be formed over the air gap.

Certain embodiments described herein relate to non-planar transistors. Non-planar transistors are three-dimensional electronic devices that deviate from a traditional flat transistor design. Compared to planar transistors, non-planar transistors can provide improved control over current flow, reduced leakage, and enhanced performance, making it a key technology for smaller, faster, and more energy-efficient electronic devices. Examples of non-planar transistors include fin-shaped field-effect transistors, referred to as FinFETs, and gate-all-around (GAA) transistors. FinFETs have a gate material that often surrounds a fin-shaped channel region on three sides. GAA transistors, also referred to as surrounding-gate transistors, have a gate material that surrounds a channel region on all sides. GAA transistors may be nanoribbon-based or nanowire-based.

In a nanoribbon transistor, a gate stack that may include one or more gate electrode materials and a gate dielectric may be provided around a portion of an elongated semiconductor structure called "nanoribbon", forming the gate stack on all sides of the nanoribbon. A source region and a drain region are provided on the opposite ends of the nanoribbon(s) and on either side of the gate stack, forming, respectively, a source and a drain of the nanoribbon transistor. The source and drain regions are insulated from the gate stack, so that the voltages at the three terminals (gate, source, and drain) may be separately controlled.

Non-planar transistors provide several advantages over planar transistor architectures. For example, non-planar transistors provide improved electrostatic transistor control and faster transistor speeds relative to other transistor architectures. For certain applications, nanoribbon-based channels are particularly advantageous, providing increased drive current at smaller scales relative to other non-planar architectures.

Certain embodiments described herein relate to IC devices that include multiple transistor layers, e.g., stacked transistor layers. One example of a stacked transistor device is a complementary field-effect transistor (CFET) device. A CFET is a type of transistor configuration that combines both N-channel and P-channel field-effect transistors (FETs) within the same circuit. This design allows for efficient digital and analog circuitry, especially in complementary metal-oxide-semiconductor (CMOS) technology. In a CFET arrangement, the N-channel FET may operate as an enhancement mode transistor, while the P-channel FET may operate as a depletion mode transistor. When used together, these transistors complement each other's behavior. CFETs may be employed in digital logic gates, memory cells, and various integrated circuits (ICs). The complementary nature of CFETs may reduce power consumption and/or enhance overall circuit performance in modern electronic devices.

When a CFET architecture is used, a layer of NMOS devices may be stacked over a layer of PMOS devices, or vice versa. The CFET transistors may have a non-planar transistor architecture, e.g., the transistors may be FinFETs, gate all-around transistors, nanoribbon transistors, nanowire transistors, or another transistor architecture. In some cases, individual transistors may be aligned and stacked, e.g., an NMOS transistor in the NMOS layer may be stacked over a PMOS transistor in the PMOS layer. A pair of transistors (e.g., a stacked NMOS and PMOS transistor) may be coupled together in a circuit, e.g., connected in parallel or in series with each other.

IC devices typically include a metallization stack, which is a collection of several metal layers, stacked above one another, in which different interconnects are provided. As noted above, in some device architectures, both front side interconnect layers and back side interconnect layers, also referred to as front side metallization and back side metallization, are included. The front and back side metallization are provided on opposite sides of the transistor layer. Interconnect layers, also referred to as metal layers, include electrically conductive trenches, also referred to as lines, which provide connectivity across the layer, and electrically conductive vias (or, simply, "vias") that provide electrical connectivity between different layers. In general, the term "trench" or "line" may be used to describe an electrically conductive element isolated by an insulator material (e.g., an insulator material typically comprising a low-k dielectric) that is provided in a plane parallel to the plane of an IC die/chip or a support structure over which an IC structure is provided, while the term "via" may be used to describe an electrically conductive element that interconnects two or more trenches of different levels of a metallization stack, or a component of the transistor layer and one or more trenches of a metallization layer. To that end, a via may be provided substantially perpendicularly to the plane of an IC die/chip or a support structure over which an IC structure is provided, and the via may interconnect two trenches in adjacent levels, two trenches in not adjacent levels, and/or a component of a transistor layer and a trench in adjacent or not adjacent layers. Sometimes, trenches and vias may be referred to as "metal trenches/tracks/lines/traces" and "metal vias", respectively, to highlight the fact that these elements include electrically conductive materials such as, but not limited to, metals. Together, trenches and vias may be referred to as "interconnects," where the term "interconnect" may be used to describe any element formed of an electrically conductive material for providing electrical connectivity to/from one or more components associated with an IC or/and between various such components.

The transistor layers with air gaps described herein may be implemented in one or more components associated with an IC. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value, unless specified otherwise. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

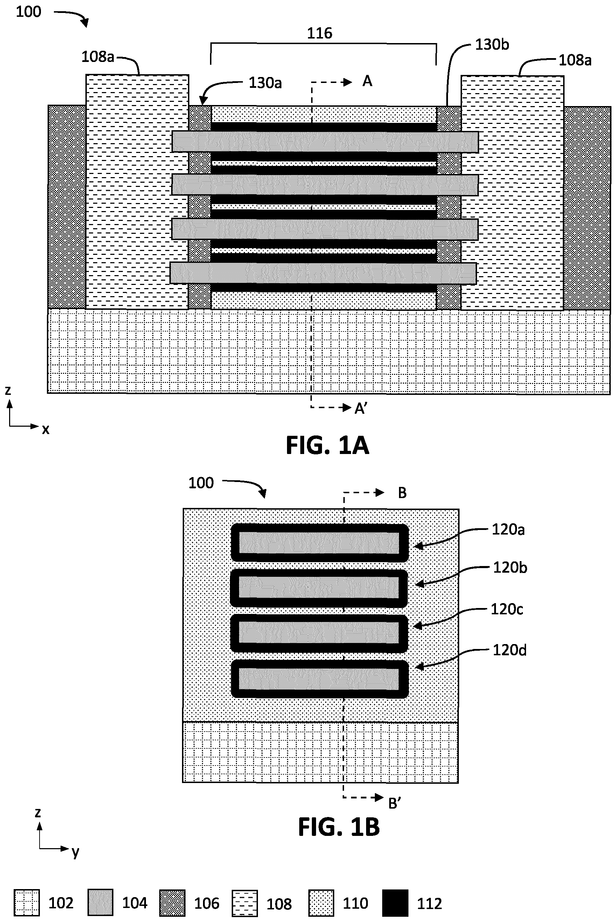

For convenience, if a collection of drawings designated with different letters are present, e.g., FIGS. 1A-1B, such a collection may be referred to herein without the letters, e.g., as "FIG. 1."

### Example nanoribbon transistor

FIGs. 1A-1B illustrate an example architecture of a nanoribbon-based transistor. FIG. 1A is a cross-section across a transistor 100 showing the source, gate, and drain. FIG. 1B is a cross-section across the gate regions of the transistor 100. FIG. 1B is a cross-section through the plane AA' in FIG. 1A, and FIG. 1A is a cross-section through the plane BB' in FIG. 1B.

A number of elements referred to in the description of FIGs. 1A, 1B, and 3-10, and with reference numerals are illustrated in these figures with different patterns, with a legend at the bottom of the page showing the correspondence between the reference numerals and patterns. The legend illustrates that FIGs. 1A and 1B use different patterns to show a support structure 102, a channel material 104, a dielectric material 106, a source or drain (S/D) region 108, a gate electrode 110, and a gate dielectric 112.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

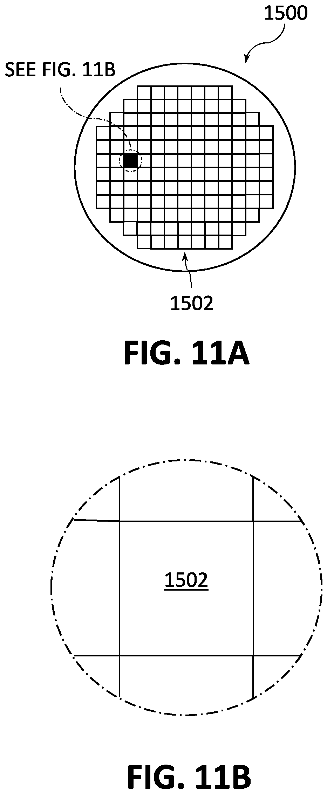

In general, implementations of the present disclosure may be formed or carried out on a support structure, e.g., the support structure 102 illustrated in FIG. 1. The support structure 102 may be, e.g., a substrate, a die, a wafer or a chip. For example, the support structure may be the wafer 1500 of FIG. 11A, discussed below, and may be, or be included in, a die, e.g., the singulated die 1502 of FIG. 11B, discussed below. The support structure 102 extends along the x-y plane in the coordinate system shown in FIG. 1. In some embodiments, a support structure 102 may be used during a fabrication process and later removed. For example, a top side of the transistor 100 may be attached to a second support structure (e.g., a second one of the support structures 102, which may be referred to as a carrier structure), and the support structure 102 over which the transistor 100 is formed may be removed to expose the back side of the transistor 100.

In some embodiments, the support structure may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more nanoribbon transistors, as described herein, may be built falls within the spirit and scope of the present disclosure.

In FIGs. 1A and 1B, a transistor 100 is formed over a support structure 102. The transistor 100 includes a channel material 104 formed into four nanoribbons stacked on top of each other. In other examples, the transistor 100 may include more or fewer nanoribbons, e.g., one, two, three, five, six or more nanoribbons. The channel material 104 may be a semiconductor, such as silicon or other semiconductor materials described herein.

The transistor 100 includes nanoribbons 120a, 120b, 120c, and 120d, referred to collectively as nanoribbons 120 or individually as a nanoribbon 120. Each nanoribbon 120 is at a different height in the z-direction in the orientation shown in FIGs. 1A and 1B, i.e., a different distance from the support structure 102, where the nanoribbon 120a is the greatest distance from the support structure 102, and the nanoribbon 120d is the smallest distance from the support structure 102. S/D regions 108a and 108b are formed at either end of the nanoribbon channels 120, as illustrated in FIG. 1A.

In general, to form nanoribbon channels such as the nanoribbon channels 120, alternating layers of the channel material 104 and a sacrificial material are deposited over the support structure 102. The sacrificial material is removed from the stack and replaced with other material, e.g., material for forming a gate stack 116, so the sacrificial material is not shown in FIG. 1. The channel material 104 and sacrificial materials include different materials. In one example, the channel material 104 is silicon, while the sacrificial material includes silicon and germanium. The sacrificial material may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material (or substantially monocrystalline layers) may be formed over each other. In different embodiments, the channel material 104 and/or the sacrificial material may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the channel material 104 may be composed of semiconductor material systems including, for example, N-type or P-type materials systems. In other embodiments, the channel material 104 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The channel material 104 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In some embodiments, multiple channel materials may be included within an IC device. For example, an IC device may include both N-type metal-oxide-semiconductor (NMOS) transistors and P-type MOS (PMOS) transistors, e.g., alternating rows of NMOS and PMOS transistors. NMOS and PMOS logic can use different groups of channel material 104, e.g., silicon may be used to form an N-type semiconductor channel, while silicon germanium may be used to form a P-type semiconductor channel. In some embodiments, a single channel material 104 is used (e.g., silicon), and different portions (e.g., channel material to form different transistors) may include different dopants, e.g., N-type dopants for NMOS transistors and P-type dopants for PMOS transistors.

The S/D regions 108 may be formed from one or more layers of doped semiconductors, metals, metal alloys, or other materials. In some embodiments described herein, the S/D regions 108 may include a doped semiconductor, such as silicon or another semiconductor doped with an N-type dopant or a P-type dopant. In some embodiments, the S/D regions 108 may include multiple layers with different levels of conductivity, e.g., a doped semiconductor followed by a more highly doped semiconductor, or a semiconductor followed by metal.

A central portion of each of the nanoribbon channels 120 is surrounded by a gate stack 116, which in this example, includes a gate electrode 110 and gate dielectric 112. Nanoribbon transistors often include a gate dielectric that surrounds the nanoribbon channels 120, and a gate electrode that surrounds the gate dielectric. While not specifically shown, in some embodiments, the gate dielectric 112 around each nanoribbon channel 120 includes multiple layers, e.g., an oxide layer and a high-k dielectric layer. The oxide layer may be grown directly on the nanoribbon channels 120, and the high-k dielectric may surround the oxide. The oxide may include oxygen in combination with the channel material 104. For example, if the nanoribbon channels are formed from silicon, the gate dielectric 112 may include a layer of silicon oxide. The high-k dielectric may be formed over the oxide. The gate electrode 110 surrounds the gate dielectric 112, e.g., the high-k dielectric (if included). In this example, the gate electrode 110 is above and below the nanoribbon stack, and between adjacent nanoribbons 120.

The gate electrode 110 includes a conductive material, such as a metal. The gate electrode 110 may include at least one P-type work function metal or N-type work function metal, depending on whether the transistor 100 is a PMOS transistor or an NMOS transistor. For a PMOS transistor, metals that may be used for the gate electrode 110 may include, but are not limited to, ruthenium, palladium, platinum, cobalt, nickel, and conductive metal oxides (e.g., ruthenium oxide). For an NMOS transistor, metals that may be used for the gate electrode 110 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 110 may include a stack of two or more metal layers, where one or more metal layers are work function metal layers and at least one metal layer is a fill metal layer.

In various embodiments, the gate dielectric 112 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, the gate dielectric 112 may have a thickness between about 0.5 nanometers and 3 nanometers, including all values and ranges therein, e.g., between about 1 and 3 nanometers, or between about 1 and 2 nanometers.

Regions of the transistor 100 outside of the nanoribbons 120, gate stack 116, and S/D regions 108 are filled in with a dielectric material 106. In the region between the gate stack 116 and the S/D regions 108, the dielectric material 106 forms a series of cavity spacers. Cavity spacers, also referred to as "dimple spacers" or "inner spacers," provide electrical isolation between the S/D regions 108 formed at the ends of the nanoribbons and the gate electrode 110 deposited around the nanoribbons 120.

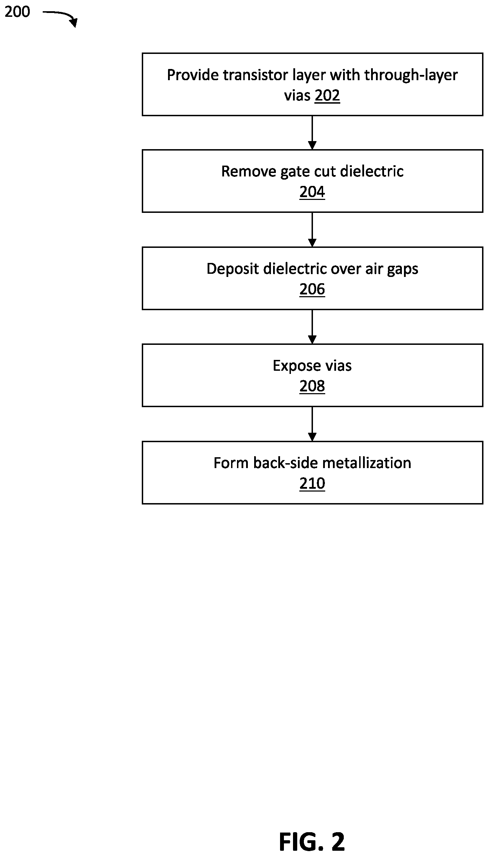

FIG. 1 illustrates a single nanoribbon transistor 100. In IC devices, many similar or identical transistors are arranged within a transistor layer. The dielectric material 106 and/or different dielectric materials may provide isolation between different transistors, or between other conductive materials in or near the transistor layer. As described with respect to FIGs. 2-10, certain portions of isolation material within a transistor layer may be removed and replaced with air gaps, forming air gapped isolation walls. Air has a lower dielectric constant than typical dielectric materials, so including air gaps may reduce parasitic capacitance within the transistor layer.

### Example process for forming transistor device with air gaps

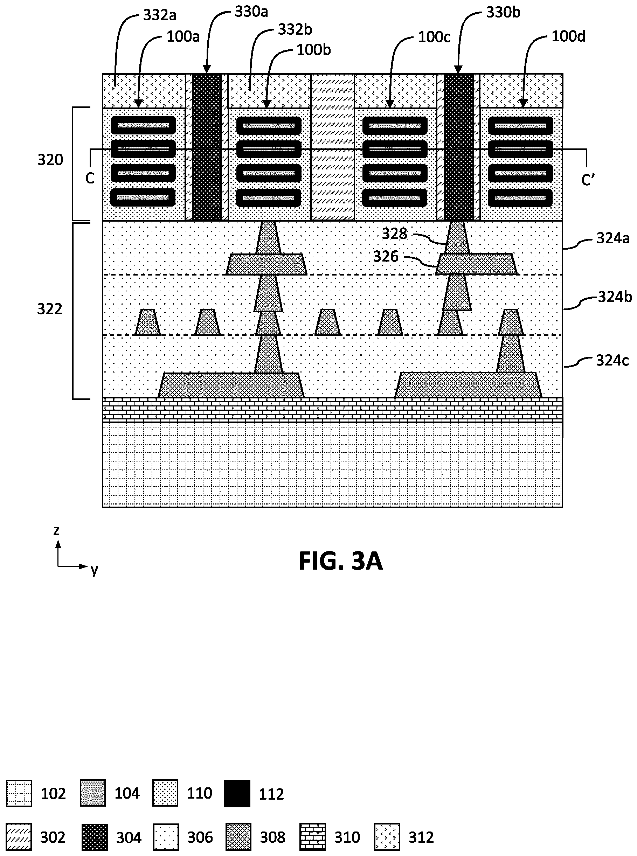

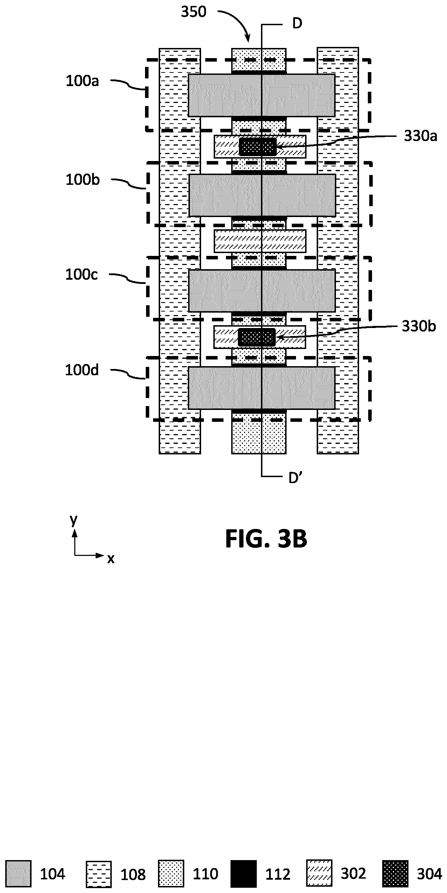

FIG. 2 is a flowchart illustrating an example processing method 200 for fabricating a device with air gaps in the transistor layer, according to some embodiments of the present disclosure. FIGs. 3-7 illustrate various steps in the processing method 200 of FIG. 2, according to some embodiments of the present disclosure. The processing method 200 can be performed across a wafer or die, with many individual transistors formed on the wafer or die. FIGs. 3-7 illustrate cross-sections of processing steps across several transistors. The processing method 200 describes a process of fabricating a device with air gaps in the transistor layer. Additional steps may be performed before, during, and/or after the process 200 to produce a device that includes the air gaps described herein.

At 202, a transistor layer with through-layer vias is provided. For example, a transistor layer including nanoribbon transistors 100 may be fabricated using known fabrication processes. The transistor layer may be formed over a support structure, such as the support structure 102. After forming the transistor layer, a front side metallization stack may be built up over the transistor layer, i.e., over a "front side" or top of the transistor layer. The front side metallization stack may include electrical connections to S/D regions and gate electrodes. After fabrication of the front side metallization stack, a carrier structure may be attached to the top or front of the front side metallization stack, and the assembly may be flipped, so that the support structure over which the transistor layer was formed is facing up. The support structure over which the transistor layer was formed is then removed, and the ends of vias that extend through the transistor layer are exposed. Alternatively, if the vias were not already in the transistor layer prior to flipping the assembly, vias may be formed that extend through the transistor layer and to a front side interconnect layer.

FIGs. 3A and 3B provide cross-sections of a portion of a transistor layer over a front side metallization stack, according to some embodiments of the present disclosure. FIG. 3B is a cross-section through the plane CC' in FIG. 3A, illustrating the transistor layer and the front side metallization stack, and FIG. 3A is a cross-section through the plane DD' in FIG. 3B, illustrating a cross-section through the transistor layer. More specifically, FIGs. 3A and 3B illustrate different cross-sections through four nanoribbon transistors 100a, 100b, 100c, and 100d. The nanoribbon transistors 100a-100d are examples of the nanoribbon transistor 100 described with respect to FIG. 1. FIG. 3A illustrates the nanoribbon transistors 100 in a cross-section through the gate stack 116 in the y-z plane, which corresponds to the cross-section shown in FIG. 1B. The nanoribbon transistors 100 may be formed as described with respect to FIG. 1. The nanoribbon transistors 100 are in a transistor layer 320, which may also be referred to as a device layer 320.

In the view shown in FIG. 3A, an oxide material 312 is directly over the nanoribbon transistors 100. The oxide material 312 forms oxide regions 332, e.g., the oxide region 332a over the transistor 100a, and the oxide region 332b over the transistor 100b. The oxide material 312 may be a dielectric material that includes oxygen. The oxide regions 332 may be formed prior to forming the nanoribbon transistors 100 or at a later time, e.g., after the back side of the transistor layer 320 is exposed.

Furthermore, the nanoribbon transistors 100 are surrounded on their sides by a gate cut dielectric 302. FIG. 3B illustrates a gate line 350 that extends through the gate electrodes 110, gate dielectric 112, and the gate cut dielectric 302. FIG. 3B also illustrates the two S/D regions 108 on either side of the gate line 350. The channel material 104 of the nanoribbons extends through the gate electrode 110 and gate dielectric 112, and the channel material 104 extends between the S/D regions 108. While not illustrated in FIG. 3B, one or more other dielectric materials (e.g., the dielectric material 106) may fill other areas of the transistor layer 320 outside of the gate cut dielectric 302. Furthermore, in some cases, the gate cut dielectric 302 may be included outside of the gate area, e.g., the gate cut dielectric 302 can extend into or through areas around the S/D regions 108.

In some embodiments, the gate cut dielectric 302 is a high-k dielectric. In certain embodiments, the gate cut dielectric 302 includes nitrogen. The gate cut dielectric 302 may include silicon and nitrogen, e.g., silicon nitride. In other embodiments, the gate cut dielectric 302 may include one or more dielectric materials that may include, but are not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials include, but are not limited to silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

In the view shown in FIG. 3A, the transistor layer 320 is over (i.e., on top of) a front side metallization stack 322. The metallization stack 322 is over a support structure 102. The support structure 102 may be a carrier wafer that is coupled to the front side metallization stack 322 by a bonding layer 310. The carrier wafer may be bonded to the front side metallization stack 322 after fabrication of the front side metallization stack 322. The assembly (i.e., the transistor layer 320, front side metallization stack 322, bonding layer 310, and carrier wafer) may be flipped after bonding the carrier wafer, and a support structure over which the transistor layer 320 was formed may be removed, e.g., by grinding or polishing.

In this example, the front side metallization stack 322 includes three front side metal layers 324a, 324b, and 324c, also referred to as interconnect layers. The metal layer 324a is the nearest metal layer to the transistor layer 320, and the metal layer 324c is the farthest metal layer from the transistor layer 320. While three metal layers 324a, 324b, and 324c are illustrated in FIG. 3A, an IC device may have fewer or more front side metal layers, e.g., up to 10 metal layers, up to 15 metal layers, or more.

Each metal layer 324 includes conductive structures, including metal lines or trenches (e.g., the line 326) formed from a conductive material 308 and vias (e.g., the via 328) formed from the conductive material 308. The conductive material 308 may include one or more metals or metal alloys, with materials such as copper, ruthenium, palladium, platinum, cobalt, nickel, hafnium, zirconium, titanium, tantalum, and aluminum, tantalum nitride, tungsten, doped silicon, doped germanium, or alloys and mixtures of any of these. In some embodiments, the conductive material 308 may include one or more electrically conductive alloys, oxides, or carbides of one or more metals. While FIG. 3A illustrates the same conductive material 308 for the vias and the metal lines, at each metal layer, and for each type of interconnect, any suitable conductive material may be used. For example, in a given layer, the same conductive material may be used for both metal lines and vias, or different materials may be used for metal lines and vias. As another example, in different layers, different materials may be used for the metal lines and/or vias, e.g., ruthenium may be included in the metal lines in the metal layer 324a, while copper is included in the metal lines in the metal layer 324c. In various embodiments, conductive structures may include multiple conductive materials, e.g., a first metal as a liner, and a second metal as a fill.

The conductive material 308 may form conductive pathways to route power, ground, and/or signals to/from various components of the transistor layer 320. The arrangement of the conductive material 308 in the front side metallization stack 322 in FIG. 3A is merely illustrative, and the conductive pathways in the front side metallization stack 322 may be connected to one another in any suitable manner.

The metal lines and vias in the in the front side metallization stack 322 are surrounded by a dielectric material 306. The dielectric material 306 may be a low-k dielectric. The dielectric material 306 may include any of the materials described above with respect to the gate cut dielectric 302. In some embodiments, different dielectric materials may be included in different ones of the metal layers, e.g., the metal layer 324a may include a different dielectric material from the metal layer 324c. In some embodiments, multiple dielectric materials may be present in a given layer.

The assembly shown in FIG. 3A and 3B further includes vias 330a and 330b (referred to jointly as vias 330) between certain pairs of adjacent gates. The vias 330 are formed within the gate cut regions and between adjacent gates. The vias 330 may be used for power and/or signal delivery between the back and front sides of the transistor layer 320, e.g., between the front side metallization stack 322 and a back side metallization stack formed later in the process.

In this example, the via 330a is between the gates of the transistors 100a and 100b, and the via 330b is between the gates of the transistors 100c and 100d. In this example, there is not a via between the gates of the transistors 100b and 100c; instead, the gate cut dielectric 302 fills the area between the gates of the transistors 100b and 100c. The vias 330 include a via material 304. The via material 304 may be a conductive material, such as a metal. Any of the conductive materials 308 described above may be used as or included in the via material 304.

The vias 330a and 330b are in the transistor layer 320, and, in the orientation shown, the vias 330 extend above the transistor layer 320. The vias 330 extend downward to the front side metallization stack 322. The via 330b is over the via 328, and the via 330b is in electrical and physical contact with the via 328. To form the vias 330, a portion of the gate cut dielectric 302 is patterned and etched, and the via material 304 is deposited in the etched regions.

Returning to FIG. 2, at 204, a process to remove at least some of the gate cut dielectric is performed. The gate cut dielectric is etched from the exposed back side of the assembly, e.g., from the top of the assembly in the orientation of FIG. 3A. The etch chemistry may be highly selective to the gate cut dielectric 302 (e.g., silicon and/or nitrogen) so that other structures within the assembly are not removed or damaged by the etching process. For example, the oxide regions over the gate electrodes are left substantially intact. Removal of the gate cut dielectric forms air gaps within the transistor layer. The air gaps are created between adjacent gates and/or next to vias within the transistor layer, e.g., between a via and a gate. In some embodiments, the gate cut dielectric may be patterned, e.g., using a lithographic process, so that portions of the gate cut dielectric are removed while others are not.

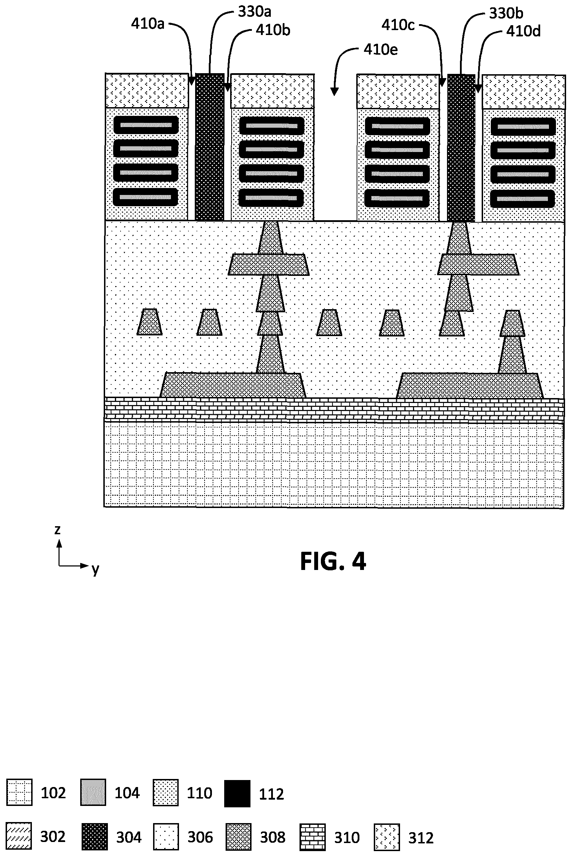

FIG. 4 is a cross-section illustrating etching of portions of the gate cut dielectric, according to some embodiments of the present disclosure. The gate cut dielectric 402 is removed between the gate electrodes 110 of the four illustrated transistors, resulting in air gaps 410a and 410b on either side of the via 330a, air gaps 410c and 410d on either side of the via 330b, and the air gap 410e between the gates of the transistors 100b and 100c.

Returning to FIG. 2, at 206, a process to deposit a dielectric over the air gaps is performed. The dielectric may form caps over the air gaps formed in the process 204. The dielectric material is deposited such that the dielectric material covers, but does not fill, the air gaps. The dielectric material may be deposited some distance into the air gaps, but at least a portion of each air gap remains after the dielectric deposition. For example, a physical vapor deposition (PVD) or chemical vapor deposition (CVD) process may be used.

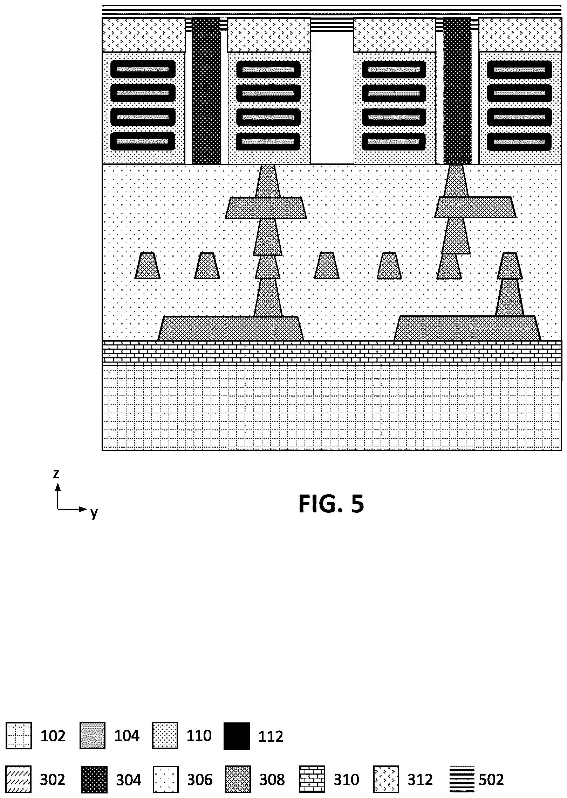

FIG. 5 is a cross-section illustrating deposition of a dielectric over the air gaps, according to some embodiments of the present disclosure. A dielectric material 502 is deposited over the oxide regions 332, air gaps 410, and vias 330. The dielectric material 502 extends partially into the air gaps 410, but does not fill the air gaps 410. Thus, the dielectric material 502 forms caps over the air gaps 410. The dielectric material 502 may include, for example, silicon and oxygen. The dielectric material 502 may include additional or alternative materials, including any of the materials described with respect to the gate cut dielectric 302.

Returning to FIG. 2, at 208, the ends of the vias are exposed, e.g., by polishing the dielectric material deposited over the oxide regions 332, air gaps 410, and vias 330. The dielectric material that filled the top portion of the air gaps remains, capping the air gaps 410.

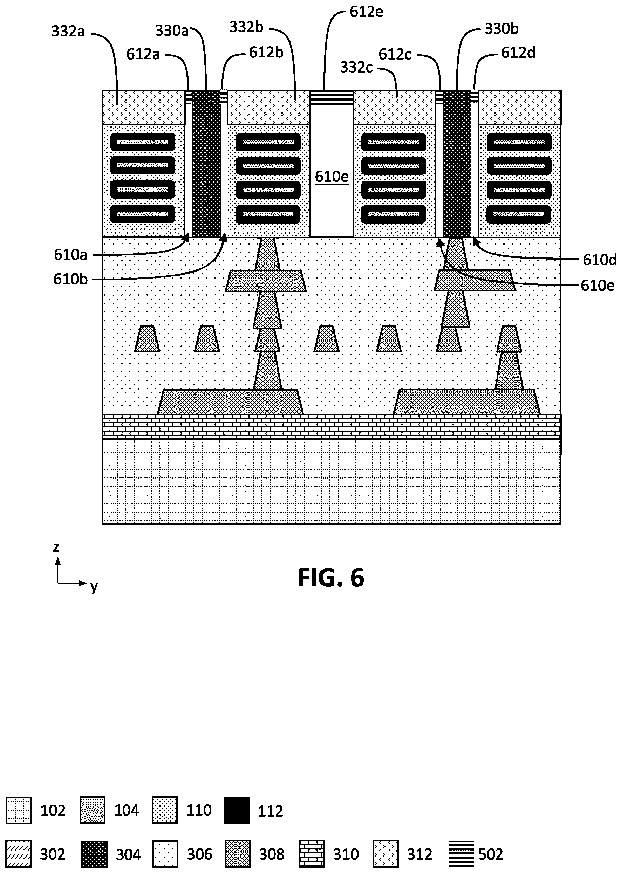

FIG. 6 is a cross-section illustrating exposure, or reveal, of the vias 330 that extend through the transistor layer 320, according to some embodiments of the present disclosure. The portion of the dielectric material 502 that extended over the oxide regions 332 and the vias 330 has been removed, exposing the upper surfaces of the vias 330a and 330b and the upper surfaces of the oxide regions 332. The portions of the dielectric material 502 within the air gaps 410 remains, forming caps 612 over the air gaps 610. The resulting air gaps 610 after formation of the caps 612 have smaller volumes than the air gaps 410, as upper portions of the air gaps 410 have been replaced with the dielectric material 502.

The cap 612a is over the air gap 610a, the cap 612b is over the air gap 610b, the cap 612c is over the air gap 610c, the cap 612d is over the air gap 610d, and the cap 612e is over the air gap 610e. The cap 612a is bounded on the left side by the oxide region 332a and on the right side by the via 330a. The cap 612b is bounded on the left side by the via 330a and on the right side by the oxide region 332b. The cap 612e is bounded on either side by the oxide regions 332b and 332c.

In this example, an interface between the air gaps 610 and the corresponding cap 612 (e.g., between the air gap 610a and the cap 612a, or between the air gap 610e and the cap 612e) is above an upper surface of the gates 110 in the orientation shown. In other embodiments, the caps 612 extend further into the air gaps 410 resulting in caps having greater heights (where height is measured in the z-direction in the coordinate system shown) and/or the oxide regions 332 have smaller heights, which may cause the interfaces between the air gaps 610 and the corresponding caps 612 to be at or below the upper surface of the gates 110.

Returning to FIG. 2, at 210, back side metallization is formed over the back side of the transistor layer, and over the capped air gaps. The back side metallization may be formed in a similar manner to the front side metallization. The back side metallization may include electrical connections to at least a portion of the vias that extend through the transistor layer.

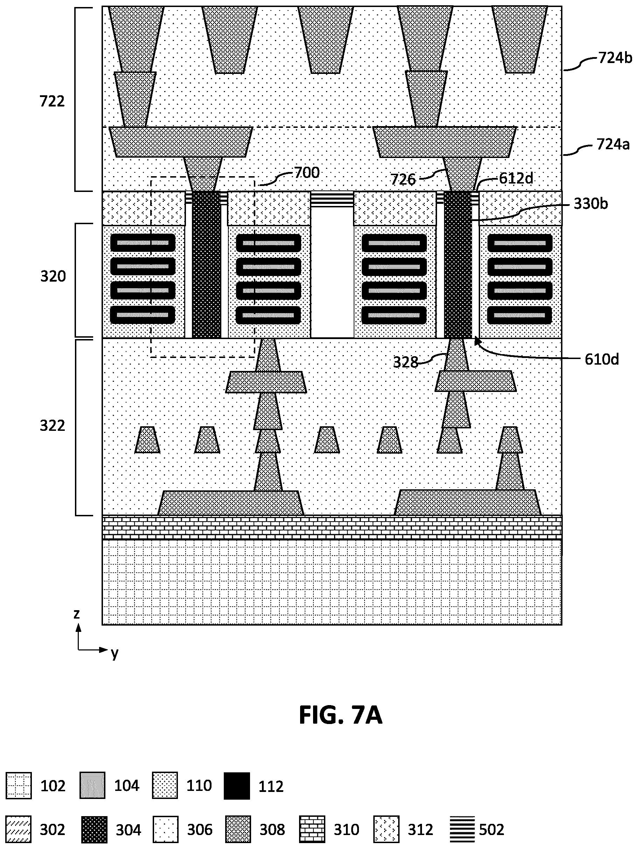

FIG. 7A is a cross-section illustrating back side interconnect layers over the capped air gaps, according to some embodiments of the present disclosure. FIG. 7A includes a back side metallization stack 722. In this example, the back side metallization stack 722 includes two back side metal layers 724a and 724b. The metal layer 724a is the nearest metal layer to the transistor layer 320, and the metal layer 724b is the farthest metal layer from the transistor layer 320. While two metal layers 724a and 724b are illustrated in FIG. 7A, an IC device may have fewer or more back side metal layers, e.g., up to 5 metal layers, up to 10 metal layers, up to 15 metal layers, or more.

Each back side metal layer 724 includes conductive structures, including metal lines or trenches formed from a conductive material 308 and vias formed from the conductive material 308. While FIG. 7A illustrates the same conductive material 308 for the vias and the metal lines within the back side metallization stack 722 that were included in the front side metallization stack 322, any suitable conductive material may be used, as described with respect to the front side metallization stack 322. Similarly, while the metal lines and vias in the in the back side metallization stack 722 are surrounded by the dielectric material 306, any suitable dielectric material or combination of dielectric materials may be used.

In the back side metallization stack 722, as with the front side metallization stack 322, the conductive material 308 may form conductive pathways to route power, ground, and/or signals to/from various components of the transistor layer 320. The arrangement of the conductive material 308 in the back side metallization stack 722 in FIG. 7A is merely illustrative, and the conductive pathways in the back side metallization stack 722 may be connected to one another in any suitable manner.

In this example, the via 330b that extends through the transistor layer 320 is coupled to the via 726 in the back side metallization stack 722. This connection may provide power delivery from the back side of the IC device, through the back side metallization stack 722, into the via 726, through the via 330b, and to the front side metallization stack 322 by way of the via 328. In this example, a portion of the via 726 is over the cap 612d; the cap 612d prevents the conductive material 308 from the via 726 from entering the air gap 610d.

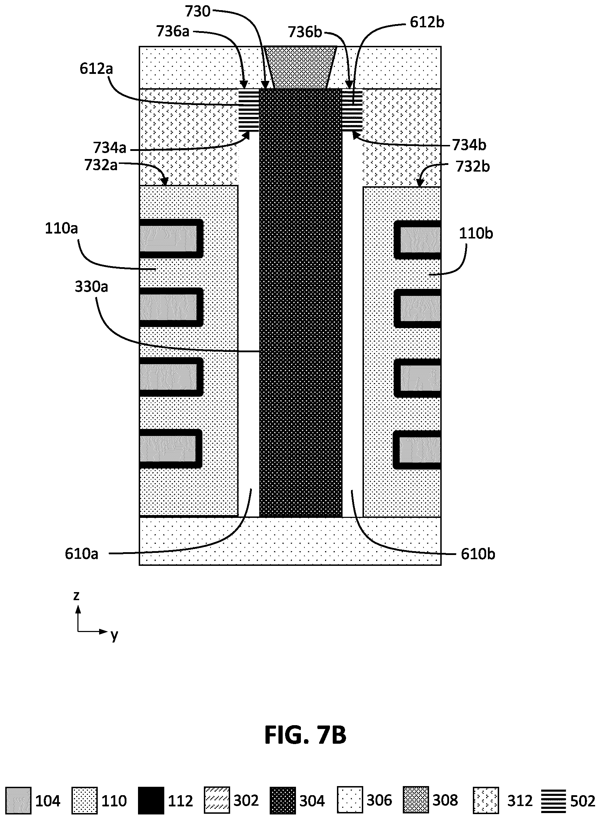

FIG. 7B is an enlarged view of a portion 700 of FIG. 7A. FIG. 7B more clearly shows a pair of air gaps 610a and 610b around the via 330a. The air gap 610a is between the gate electrode 110a of the transistor 100a and the via 330a, and the air gap 610b is between the gate electrode 110b of the transistor 100b and the via 330a. The air gaps 610 provide isolation walls between conductive components, e.g., the via 330a and the gate electrode 110a. The via 330a has an upper surface 730 that is above an upper surface 732a of the gate 110a and above an upper surface 732b of the gate 110b. The upper surface 730 of the via 330a is also above the interfaces 734a and 734b between the caps 612a and 612b and the respective air gaps 610a and 610b. The upper surface 730 of the via 330a is coplanar (i.e., at the same position in the z-dimension) with the top surfaces 736a and 736b of the caps 612a and 612b.

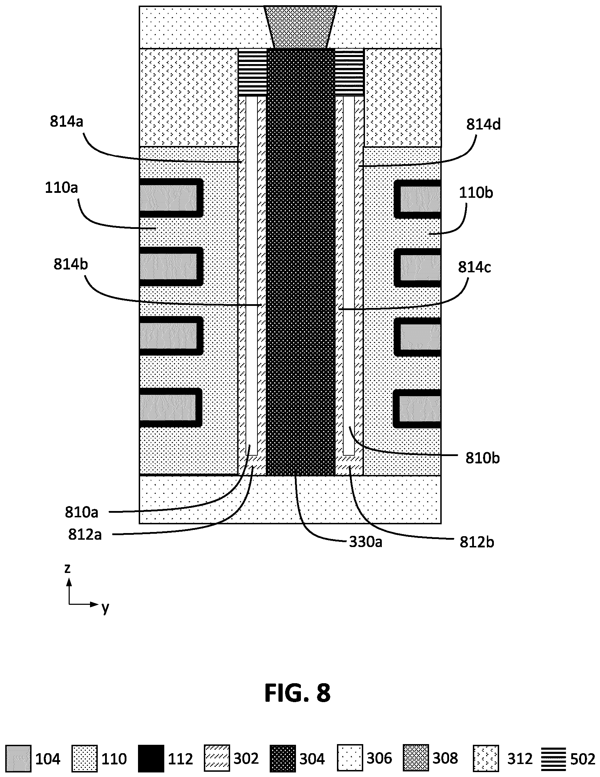

In the example shown in FIG. 7B, the gate electrodes 110a and 110b and via 330a form the sides of the air gaps 610a and 610b, and the dielectric material in the front side metallization stack 322 forms the base of the air gaps 610a and 610b. In other embodiments, a portion of the gate cut dielectric 302 remains after etching the air gaps 410 in the process 204. An example of air gaps bounded by the gate cut dielectric 302 is illustrated in FIG. 8.

FIG. 8 is similar to FIG. 7B, except that a dielectric liner is along the base and sides of the air gaps. The dielectric liner is formed from the gate cut dielectric 302, described above, that remains after the etching process 204. Around the air gap 810, the dielectric liner includes a base 812a between the dielectric material 306 in the front side metallization stack 322 and the air gap 810a. The dielectric liner around the air gap 810 further includes a first dielectric layer 814a between the gate electrode 110a and the air gap 810a; the first dielectric layer 814a extends along a side of the gate electrode 110a. The dielectric liner around the air gap 810 further includes a second dielectric layer 814b between the via 330a and the air gap 810a; the second dielectric layer 814b extends along a side of the via 330a. The air gap 810b includes a similar dielectric liner that includes a base 812b and two dielectric layers 814c and 814c along the via 330a and the gate electrode 110b, respectively. In other embodiments, a dielectric liner, similar to the bases 812a and 812b, may be along the base of the air gaps, but the layers 814a, 814b, 814c, and 814d along the sides of the air gaps may not be present.

### Air gaps in a transistor layer with back side source/drain contacts

As described above, in devices with back side contacts, e.g., back side S/D contacts, parasitic capacitance between the back side contacts, or between a back side S/D contact and another conductive structure (e.g., a gate), can occur. To reduce the parasitic capacitance in such devices, air gaps may be formed between adjacent S/D regions in the transistor layer.

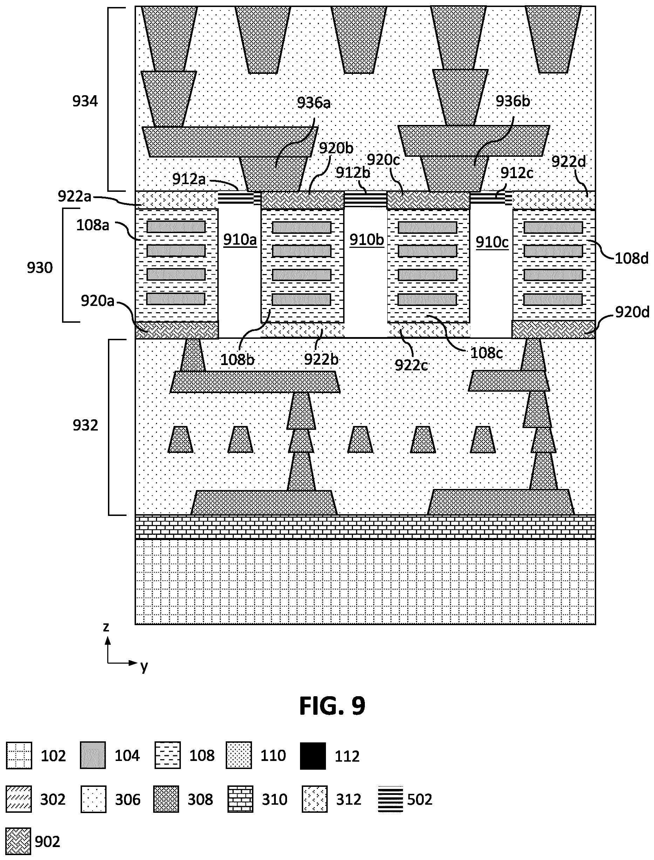

FIG. 9 is a cross-section illustrating air gaps within a transistor layer with back side S/D contacts, according to some embodiments of the present disclosure. FIG. 9 illustrates a cross-section through a row of four transistors, and in particular, through the S/D regions of four nanoribbon transistors that are similar to the transistor 100. Rather than illustrating nanoribbon channels surrounded by the gate electrode 110 and gate dielectric 112, e.g., as shown in FIGs. 1 and 3, the cross-section in FIG. 9 illustrates a cross-section in a y-z plane through the S/D contacts, e.g., a series of four S/D regions 108a, 108b, 108c, and 108c of four respective transistors 100.

The transistors 100 are within a transistor layer 930. In the orientation shown, the transistor layer 930 is over a front side metallization stack 932 and under a back side metallization stack 934, which are similar to the front side metallization stack 322 and back side metallization stack 722, respectively.

Each S/D region 108 may be physically and electrically coupled to a S/D contact 920. In some cases, certain ones of the S/D regions 108 may not be coupled to a S/D contact, or be connected to a dummy contact. In the example shown, S/D contacts 920 are on either the front side or the back side of the S/D region 108. In particular, the S/D regions 108a and 108d each have a front side contact 920a or 920d, and the S/D regions 108b and 108c each have a back side contact 920b or 920c. Each of the contacts 920 is coupled to interconnect structures in the adjoining metallization stack 932 or 934. In this example, on the opposite side of the contact 920 is an oxide region 922. In particular, the S/D regions 108a and 108d have an oxide region 922a or 922d on the back side; the S/D regions 108b and 108c have an oxide region 922b or 922c on the front side. In other examples, one or more S/D regions 108 may have S/D contacts 920 on both the front side and back side, or oxide regions 922 on both the front side and back side (e.g., at a dummy device).

Air gaps 910a-910c are between adjacent S/D regions 108. For example, the air gap 910a is between the S/D regions 108a and 108b, and the air gap 910b is between the S/D regions 108b and 108c. The air gaps 910 are formed in a similar manner to the air gaps 610, described above. Each air gap 910 has a respective dielectric cap 912a, 912b, or 912c, formed from the dielectric material 502. The dielectric caps 912 extend between adjacent oxide regions 922 or contacts 920. For example, the dielectric cap 912a is bounded on its left side by the oxide region 922a and on its right side by the back side contact 920b. The top of the cap 912a is coplanar (i.e., at the same position in the z-dimension) with the oxide region 922a and the back side contact 920b.

The caps 912 prevent material (e.g., the conductive material 308 in the back side metallization stack 934) from entering the air gaps 910. As illustrated in FIG. 9, in some cases, conductive structures within the back side metallization stack 934 may be directly over the caps 912. For example, the via 936a in the back side metallization stack 934 is over and in contact with the dielectric cap 912a, and the via 936b in the back side metallization stack 934 is over and in contact with the dielectric cap 912c.

As described with respect to FIG. 8, in some embodiments, a portion of a dielectric material that etched to form the air gaps 910 may remain around the air gaps 910. Thus, a layer of dielectric material may be present between the air gaps 910 and the S/D regions 108 and/or between the air gaps 910 and the dielectric material 306 in the front side metallization stack 932.

### Air gaps in stacked transistor device

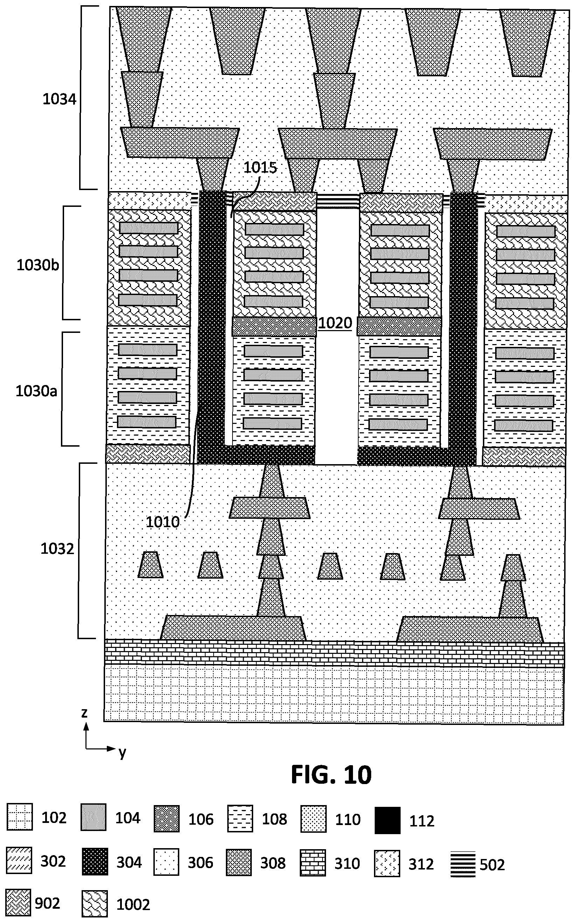

In another embodiment, air gaps are included in devices that include multiple transistor layers, such as CFET devices. FIG. 10 is a cross-section illustrating air gaps within the transistor layers of a CFET device, according to some embodiments of the present disclosure.

FIG. 10 is a cross-section through two rows having four transistors each, and in particular, through the S/D contacts of the eight nanoribbon transistors. Each individual transistor may be similar to the transistor 100. Rather than illustrating nanoribbon channels surrounded by the gate electrode 110 and gate dielectric 112, e.g., as shown in FIGs. 1 and 3, the cross-section in FIG. 10 illustrates a cross-section in a y-z plane through the S/D contacts, as described with respect to FIG. 9.

FIG. 10 includes two transistor layers 1030a and 1030b, where the transistor layer 1030b is stacked over the transistor layer 1030a. Each of the layers 1030a and 1030b includes multiple transistors with S/D regions 108 arranged along a line. In this example, the S/D regions in the layer 1030a include a first S/D material 108, and the S/D regions in the layer 1030b include a second S/D material 1002 that is different from the first S/D material 108. For example, the S/D materials 108 and 1002 may have different dopants.

A via 1010 extends through both the transistor layers 1030a and 1030b. The via 1010 is between a pair of adjacent S/D regions in the transistor layer 1030a and between another pair of adjacent S/D regions in the transistor layer 1030b. The via 1010 may also extend between a pair of adjacent gate regions in the transistor layers 1030a and 1030b (e.g., the via 1010 extends in the x-direction in the coordinate system shown into a gate region). Alternatively, the via 1010 may only be in the gate region, e.g., similar to the position shown in FIG. 3B. The via 1010 is coupled, at a front side, to a conductive structure (here, a via) in the back side metallization stack 1034, which is similar to the back side metallization stack 934 of FIG. 9. The via 1010 is coupled, at a back side, to a S/D region of a transistor in the layer 1030a. In this example, the via 1010 is also coupled to a via in the front side metallization stack 1032; in other examples, the via 1010 may not be electrically coupled to the front side metallization. The front side metallization stack 1032 is similar to the front side metallization stack 932 of FIG. 9. Other ones of the S/D regions are coupled to front side contacts or back side contacts, similar to the contacts 920 described with respect to FIG. 9.

A dielectric material 106 is between certain ones of the S/D regions in the transistor layer 1030a and transistor layer 1030b, while other stacked S/D regions of the transistor layer transistor layer 1030a and transistor layer 1030b are in physical and electrical contact. The oxide material 312 is over the S/D regions over two of the transistors in the transistor layer 1030b, similar to the oxide regions 922 of FIG. 9. In other embodiments, the dielectric material 106 and/or oxide material 312 may be arranged differently, e.g., a dielectric material 106 may be included between all of the stacked S/D regions in the layers 1030a and 1030b, or different ones of the stacked S/D regions.

Air gaps, such as the air gap 1015, are formed between S/D regions and the vias that extend through the transistor layers 1030a and 1030b. In areas that do not have vias, air gaps, such as the air gap 1020, are formed between adjacent S/D regions. The air gaps 1015 and 1020 extend across the two transistor layers 1030a and 1030b. Dielectric caps, similar to the dielectric caps 612 and 912, are formed at the front or tops of the air gaps 1015 and 1020.

### Example devices

The circuit devices with transistor layers with air gapped isolation walls disclosed herein may be included in any suitable electronic device. FIGS. 11-14 illustrate various examples of apparatuses that may include the one or more transistors disclosed herein, which may have been fabricated using the processes disclosed herein.

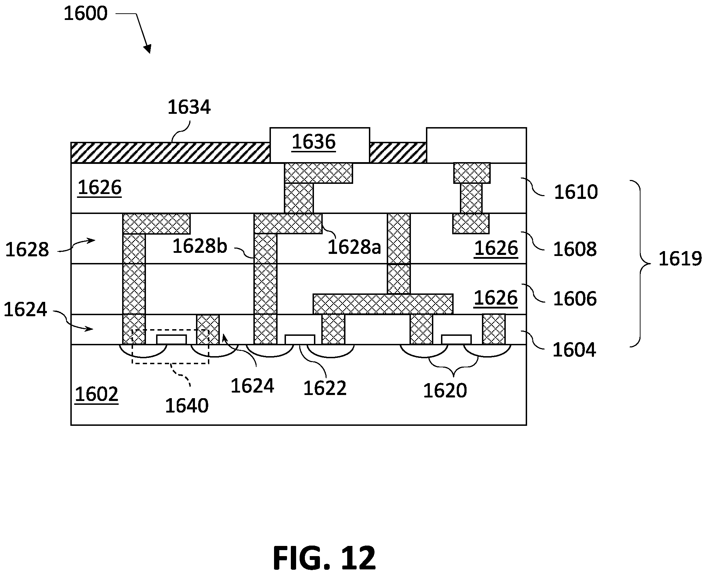

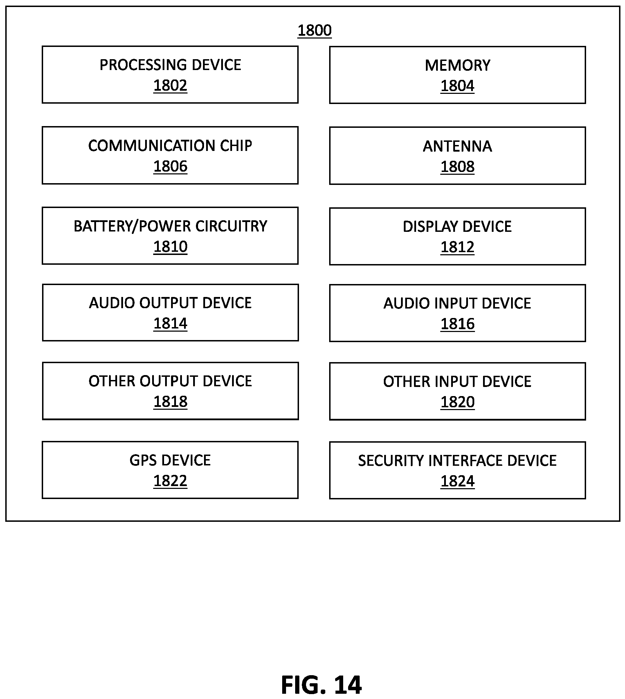

FIG. 11A and 11B are top views of a wafer and dies that include one or more IC structures including one or more transistor layers with air gapped isolation walls in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 2-14, or any further embodiments of the IC structures described herein). After the fabrication of the semiconductor product is complete (e.g., after manufacture of one or more IC structures with one or more of the transistors as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more of the transistors as disclosed herein may take the form of the wafer 1500 (e.g., not singulated) or the form of the die 1502 (e.g., singulated). The die 1502 may include one or more transistors (e.g., one or more of the transistors 1640 of FIG. 12, discussed below) and/or supporting circuitry to route electrical signals to the transistors, as well as any other IC components (e.g., one or more of the non-planar transistors described herein). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 14) or other logic that is configured to store information in the memory devices or execute instructions stored in the memory array.

FIG. 12 is a cross-sectional side view of an IC device 1600 that may include one or more transistor layers with air gapped isolation walls in accordance with any of the embodiments disclosed herein. The IC device 1600 may be formed on a substrate 1602 (e.g., the wafer 1500 of FIG. 11A) and may be included in a die (e.g., the die 1502 of FIG. 11B). The substrate 1602 may be any substrate as described herein. The substrate 1602 may be part of a singulated die (e.g., the dies 1502 of FIG. 11B) or a wafer (e.g., the wafer 1500 of FIG. 11A).

The IC device 1600 may include one or more device layers 1604 disposed on the substrate 1602. The device layer 1604 may include features of one or more transistors 1640 (e.g., metal-oxide-semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 12 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross-section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more transistor layers with air gapped isolation walls at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 12 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 12). Although a particular number of interconnect layers 1606-1610 is depicted in FIG. 12, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 12. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 12. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

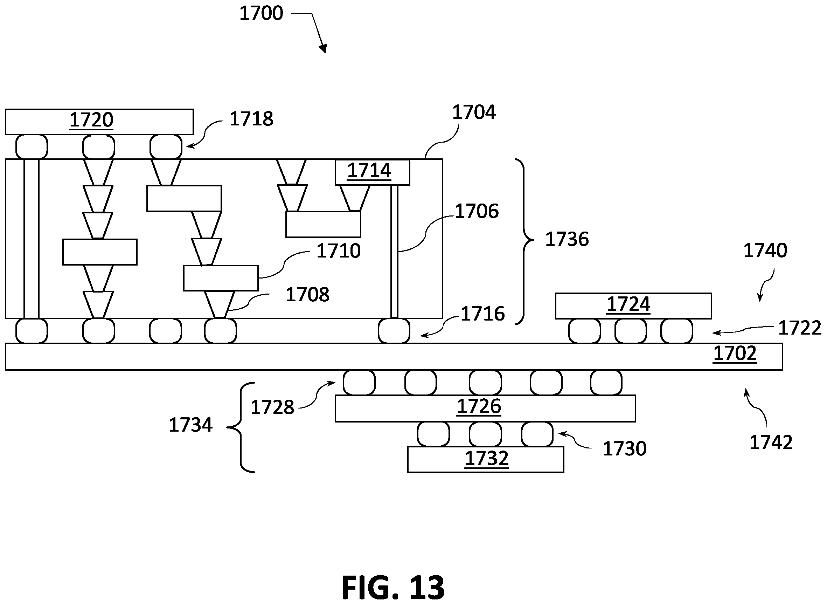

FIG. 13 is a cross-sectional side view of an IC device assembly 1700 that may include components having or being associated with (e.g., being electrically connected by means of) one or more transistor layers with air gapped isolation walls in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include one or more of the non-planar transistors disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 13 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 13), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 13, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 11B), an IC device (e.g., the IC device 1600 of FIG. 12), or any other suitable component. In some embodiments, the IC package 1720 may include one or more transistor layers with air gapped isolation walls, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 13, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 13 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 14 is a block diagram of an example computing device 1800 that may include one or more transistor layers with air gapped isolation walls in accordance with any of the embodiments disclosed herein. For example, any suitable ones of the components of the computing device 1800 may include a die (e.g., the die 1502 (FIG. 11B)) having one or more transistor layers with air gapped isolation walls. Any one or more of the components of the computing device 1800 may include, or be included in, an IC device 1600 (FIG. 12). Any one or more of the components of the computing device 1800 may include, or be included in, an IC device assembly 1700 (FIG. 13).

A number of components are illustrated in FIG. 14 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 14, but the computing device 1800 may include interface circuitry for coupling to the one or more components. For example, the computing device 1800 may not include a display device 1812, but may include display device interface circuitry (e.g., a connector and driver circuitry) to which a display device 1812 may be coupled. In another set of examples, the computing device 1800 may not include an audio input device 1816 or an audio output device 1814, but may include audio input or output device interface circuitry (e.g., connectors and supporting circuitry) to which an audio input device 1816 or audio output device 1814 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random-access memory (STT-MRAM).

In some embodiments, the computing device 1800 may include a communication chip 1806 (e.g., one or more communication chips). For example, the communication chip 1806 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1806 may implement any of a number of wireless standards or protocols, including but not limited to Institute for Electrical and Electronic Engineers (IEEE) standards including Wi-Fi (IEEE 1402.11 family), IEEE 1402.18 standards (e.g., IEEE 1402.18-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.18 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.18 standards. The communication chip 1806 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1806 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1806 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1806 may operate in accordance with other wireless protocols in other embodiments. The computing device 1800 may include an antenna 1808 to facilitate wireless communications and/or to receive other wireless communications (such as AM or FM radio transmissions).

In some embodiments, the communication chip 1806 may manage wired communications, such as electrical, optical, or any other suitable communication protocols (e.g., the Ethernet). As noted above, the communication chip 1806 may include multiple communication chips. For instance, a first communication chip 1806 may be dedicated to shorter-range wireless communications such as Wi-Fi or Bluetooth, and a second communication chip 1806 may be dedicated to longer-range wireless communications such as GPS, EDGE, GPRS, CDMA, WiMAX, LTE, EV-DO, or others. In some embodiments, a first communication chip 1806 may be dedicated to wireless communications, and a second communication chip 1806 may be dedicated to wired communications.

The computing device 1800 may include a battery/power circuitry 1810. The battery/power circuitry 1810 may include one or more energy storage devices (e.g., batteries or capacitors) and/or circuitry for coupling components of the computing device 1800 to an energy source separate from the computing device 1800 (e.g., AC line power).

The computing device 1800 may include a display device 1812 (or corresponding interface circuitry, as discussed above). The display device 1812 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1814 (or corresponding interface circuitry, as discussed above). The audio output device 1814 may include any device that generates an audible indicator, such as speakers, headsets, or earbuds, for example.

The computing device 1800 may include an audio input device 1816 (or corresponding interface circuitry, as discussed above). The audio input device 1816 may include any device that generates a signal representative of a sound, such as microphones, microphone arrays, or digital instruments (e.g., instruments having a musical instrument digital interface (MIDI) output).

The computing device 1800 may include another output device 1818 (or corresponding interface circuitry, as discussed above). Examples of the other output device 1818 may include an audio codec, a video codec, a printer, a wired or wireless transmitter for providing information to other devices, or an additional storage device.

The computing device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may include a global positioning system (GPS) device 1822 (or corresponding interface circuitry, as discussed above). The GPS device 1822 may be in communication with a satellite-based system and may receive a location of the computing device 1800, as known in the art.

The computing device 1800 may include a security interface device 1824. The security interface device 1824 may include any device that provides security features for the computing device 1800 or for any individual components therein (e.g., for the processing device 1802 or for the memory 1804). Examples of security features may include authorization, access to digital certificates, access to items in keychains, etc. Examples of the security interface device 1824 may include a software firewall, a hardware firewall, an antivirus, a content filtering device, or an intrusion detection device.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an integrated circuit (IC) device including a first transistor including a first gate; a second transistor including a second gate, the first gate and the second gate arranged along a gate line; a conductive structure between the first gate and the second gate; a first air gap between the conductive structure and the first gate; and a second air gap between the conductive structure and the second gate.

Example 2 provides the IC device of example 1, further including a first cap over the first air gap and a second cap over the second air gap, the first cap and the second cap including a dielectric material.

Example 3 provides the IC device of example 2, where the conductive structure has an upper surface higher than an upper surface of the first gate of the first transistor.

Example 4 provides the IC device of example 2 or 3, where the conductive structure has an upper surface above an interface between the first cap and the first air gap.

Example 5 provides the IC device of any of examples 2-4 where the conductive structure has an upper surface in a same plane as an upper surface of the first cap.

Example 6 provides the IC device of any preceding example, further including a dielectric layer between the first gate and the air gap, the dielectric layer along a side of the first gate.

Example 7 provides the IC device of example 6, further including a second dielectric layer between the conductive structure and the air gap, the second dielectric layer along a side of the conductive structure.

Example 8 provides the IC device of any preceding example, where the first transistor and the second transistor are over a front side interconnect layer, the front side interconnect layer including a second conductive structure coupled to the conductive structure.

Example 9 provides the IC device of example 8, further including a back side interconnect layer over the first transistor and the second transistor, the back side interconnect layer including a third conductive structure coupled to the conductive structure.

Example 10 provides the IC device of any preceding example, further including a third transistor including a third gate, the third transistor arranged along the gate line, and the third transistor adjacent to the second transistor; and a third air gap between the second gate and the third gate.

Example 11 provides an integrated circuit (IC) device including a first transistor layer including a first transistor including a first source or drain region; a second transistor including a second source or drain region, the first source or drain region and the second source or drain region arranged along a first line; a second transistor layer over the first transistor layer, the second transistor layer including a third transistor including a third source or drain region; and a fourth transistor including a fourth source or drain region, the third source or drain region and the fourth source or drain region arranged along a second line; a conductive structure extending through the first transistor layer and the second transistor layer, the conductive structure between the first source or drain region and the second source or drain region; and an air gap between the conductive structure and the first source or drain region.

Example 12 provides the IC device of example 11, where the second line is over the first line, and the conductive structure is between the third source or drain region and the fourth source or drain region.

Example 13 provides the IC device of example 11 or 12, further including a second air gap between the conductive structure and the second source or drain region.

Example 14 provides the IC device of any of examples 11-13, where the conductive structure is electrically coupled to the second source or drain region of the second transistor.

Example 15 provides the IC device of example 14, further including a back side interconnect layer over the second transistor layer, where the conductive structure is electrically coupled to an interconnect structure in the back side interconnect layer.

Example 16 provides the IC device of any of example 11-15, where the first source or drain region includes a first dopant, and the third source or drain region includes a second dopant different from the first dopant.

Example 17 provides an integrated circuit (IC) device including a first transistor including a first source or drain region; a second transistor including a second source or drain region; an air gap between the first source or drain region and the second source of drain region; a first conductive contact on a front side of the first source or drain region; and a second conductive contact on a back side of the second source or drain region.

Example 18 provides the IC device of example 17, further including a dielectric cap over the air gap, the dielectric cap in contact with the second conductive contact.

Example 19 provides the IC device of example 18, where the second conductive contact has an upper surface in a same plane as an upper surface of the first cap.

Example 20 provides the IC device of any of examples 17-19, further including a dielectric layer between the first source or drain region and the air gap, the dielectric layer along a side of the first source or drain region.

Example 21 provides the IC device of any of examples 17-20, further including a back side interconnect layer over the first transistor and the second transistor, the back side interconnect layer including an interconnect structure coupled to the second conductive contact.

Example 22 provides the IC device of example 21, where the interconnect structure is over a dielectric cap over the air gap.

Example 23 provides the IC device of example 21 or 22, where the first transistor and the second transistor are over a front side interconnect layer, the front side interconnect layer including a second interconnect structure coupled to the first conductive contact.

Example 24 provides an IC package that includes an IC die, including one or more of the IC devices according to any one of the preceding examples. The IC package may also include a further component, coupled to the IC die.

Example 25 provides the IC package according to example 24, where the further component is one of a package substrate, a flexible substrate, or an interposer.

Example 26 provides the IC package according to examples 24 or 25, where the further component is coupled to the IC die via one or more first level interconnects.

Example 27 provides the IC package according to example 26, where the one or more first level interconnects include one or more solder bumps, solder posts, or bond wires.

Example 28 provides a computing device that includes a circuit board; and an IC die coupled to the circuit board, where the IC die includes one or more of the transistor/IC devices according to any one of the preceding examples (e.g., transistor/IC devices according to any one of examples 1-23), and/or the IC die is included in the IC package according to any one of the preceding examples (e.g., the IC package according to any one of examples 24-27).

Example 29 provides the computing device according to example 28, where the computing device is a wearable computing device (e.g., a smart watch) or hand-held computing device (e.g., a mobile phone).

Example 30 provides the computing device according to examples 28 or 29, where the computing device is a server processor.

Example 31 provides the computing device according to examples 28 or 29, where the computing device is a motherboard.

Example 32 provides the computing device according to any one of examples 28-31, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a first transistor comprising a first gate;
a second transistor comprising a second gate, the first gate and the second gate arranged along a gate line;
a conductive structure between the first gate and the second gate;
a first air gap between the conductive structure and the first gate; and
a second air gap between the conductive structure and the second gate.

2. The IC device of claim 1, further comprising a first cap over the first air gap and a second cap over the second air gap, the first cap and the second cap comprising a dielectric material.

3. The IC device of claim 2, wherein the conductive structure has an upper surface higher than an upper surface of the first gate of the first transistor.

4. The IC device of claim 2 or 3, wherein the conductive structure has an upper surface above an interface between the first cap and the first air gap.

5. The IC device of any of claims 2-4 wherein the conductive structure has an upper surface in a same plane as an upper surface of the first cap.

6. The IC device of any one of the preceding claims, further comprising a dielectric layer between the first gate and the air gap, the dielectric layer along a side of the first gate.

7. The IC device of claim 6, further comprising a second dielectric layer between the conductive structure and the air gap, the second dielectric layer along a side of the conductive structure.

8. The IC device of any one of the preceding claims, wherein the first transistor and the second transistor are over a front side interconnect layer, the front side interconnect layer comprising a second conductive structure coupled to the conductive structure.

9. The IC device of claim 8, further comprising a back side interconnect layer over the first transistor and the second transistor, the back side interconnect layer comprising a third conductive structure coupled to the conductive structure.

10. The IC device of any one of the preceding claims, further comprising:
a third transistor comprising a third gate, the third transistor arranged along the gate line, and the third transistor adjacent to the second transistor; and
a third air gap between the second gate and the third gate.

11. The IC device of claim 10, wherein the third air gap does not surround a conductive structure.

12. The IC device of any one of the preceding claims, wherein the first transistor and second transistor are in a first transistor layer, the IC device further comprising a second transistor layer over the first transistor layer.

13. The IC device of claim 12, wherein the conductive structure extends through the first transistor layer and the second transistor layer.

14. The IC device of claim 12 or 13, wherein the conductive structure further extends between a first source or drain region of the first transistor and a second source or drain region of the second transistor.

15. The IC device of any of claims 12-14, wherein the IC device is a complementary field-effect transistor (CFET) device.
